Europäisches Patentamt

European Patent Office

Office européen des brevets

(11) Publication number: **0 337 562**
A1

## EUROPEAN PATENT APPLICATION

(21) Application number: **89200884.8**

(22) Date of filing: **10.04.89**

(51) Int. Cl.⁴: **H01L 21/306**

(30) Priority: **14.04.88 NL 8800964**

(43) Date of publication of application:
**18.10.89 Bulletin 89/42**

(84) Designated Contracting States:
**DE FR GB IT NL**

(71) Applicant: **N.V. Philips' Gloeilampenfabrieken**
**Groenewoudseweg 1**
**NL-5621 BA Eindhoven(NL)**

(72) Inventor: **Van Arendonk, Anton Petrus Maria**
**c/o Int. Octrooibureau B.V. Prof. Holstlaan 6**
**NL-5656 AA Eindhoven(NL)**
Inventor: **Van Roosmalen, Alfred Jan**
**c/o Int. Octrooibureau B.V. Prof. Holstlaan 6**
**NL-5656 AA Eindhoven(NL)**

(74) Representative: **Rensen, Jan Geert et al**
**Internationaal Octrooibureau B.V. Prof.**
**Holstlaan 6**
**NL-5656 AA Eindhoven(NL)**

(54) **Method of manufacturing a semiconductor device.**

(57) The invention relates to a method of manufacturing a semiconductor device, in which in a silicon body (1) provided with a buried layer (3) and an epitaxial layer (4) a narrow groove is formed by plasma etching, which passes through the epitaxial layer and the buried layer.

Grooves of vertical shape can be obtained at a satisfactory etching rate if the plasma is maintained at a frequency of less than 1 MHz.

FIG. 2

## Method of manufacturing a semiconductor device.

The invention relates to a method of manufacturing a semiconductor device, in which there is etched into a monocrystalline silicon body comprising a substrate and disposed on it a highly doped buried layer and a less highly doped epitaxial layer from a free part of the surface of the epitaxial body in the silicon body in a plasma in an atmosphere containing chlorine and a carbon compound a narrow groove, which passes through the epitaxial layer and the buried layer, while the groove is filled with electrically insulating material.

The term "a narrow groove" is to be understood to mean herein a groove whose width is small with respect to the depth.

A method of the kind mentioned in the opening paragraph is known from US-PS 4,449,287, in which a plasma is maintained at a frequency of 13.56 MHz and tetrachloromethane is used as a carbon compound.

It was already known per se that an undesired etching of the highly doped layer is liable to occur with the use in plasma etching of chlorine or tetrachloromethane separately, at least if etching rates should be used which are not too low.

This then results in that the groove can be filled only with difficulty with electrically insulating material and in that a larger surface area of the silicon body is obtained for insulation purposes.

It has been found that the use in plasma etching of chlorine and tetrachloromethane together yielded favourable results, for example that under-etching of the highly doped buried layer can often be avoided.

However, these examples can often be obtained only with difficulty simultaneously with a satisfactory etching rate and a desired vertical shape of the groove.

A considerably improvement can be obtained if in the method mentioned in the opening paragraph according to the invention the groove is etched in a plasma maintained at a frequency lower than 1 MHz. Preferably, a frequency of 340 kHz is used for plasma etching.

A further improvement with regard to the steepness of the groove is obtained if during plasma etching the silicon body is kept at a temperature of at most $50\,^{\circ}$ C. Preferably, during plasma etching the temperature is kept at about $30\,^{\circ}$ C.

It has also been found that with the use of the etching frequency longer than 1MHZ as carbon compounds one or more carbon compounds from the group comprising methane, monochloromethane, dichloromethane, trichloromethane and tetrachloromethane can advantageously be used.

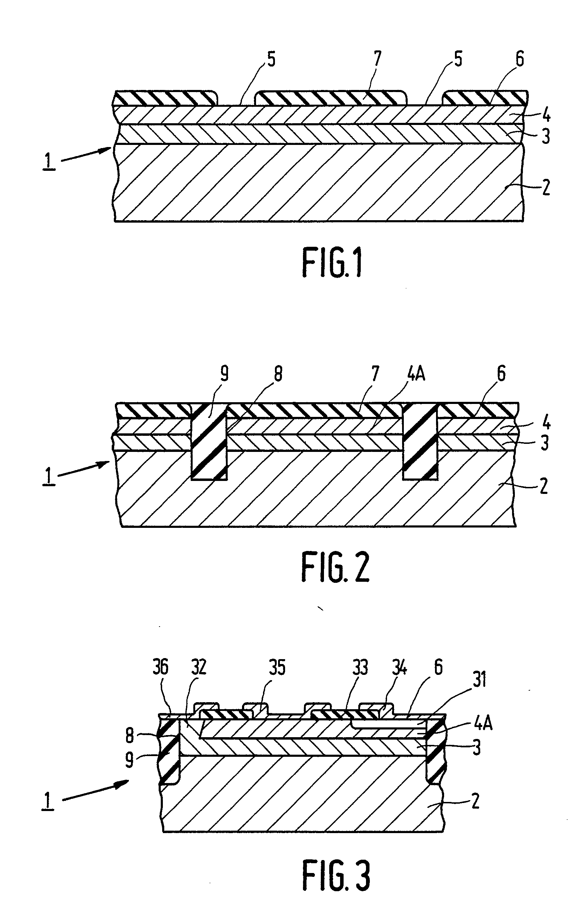

The invention will now be described with reference to the accompanying drawing and an example. In the drawing, the Figures 1 to 3 show diagramaatically and in sectional view a part of a semiconductor device at successive stages of manufacture by means of the method according to the invention. According to the example, a semiconductor device is manufactured comprising a monocrystalline silicon body 1 (cf. Figure 1) having a substrate 2 and disposed on it a highly doped buried layer 3 and a less highly doped epitaxial layer 4.

From a free part 5 of the surface 6 of the epitaxial layer 4, obtained in a usual manner by means of a thermal silicon oxide layer 7 as a mask, a narrow groove 8 is etched (cf. Figure 2), which passes through the epitaxial layer 4 and the buried layer 3 and is filled with insulating material 9.

The groove 8 is etched in a plasma in an atmosphere containing chlorine and a carbon compound.

A frequently desired vertical groove shape is obtained simultaneously with a satisfactory etching rate if according to the invention there is etched in a plasma maintained at a frequency lower than 1 MHz.

Preferably, this frequency is lower than 340 kHz.

A still better shape of the vertical groove can be obtained, if, during plasma etching, the temperature of the silicon body is not higher than $50\,^{\circ}$ C and preferably not higher than $30\,^{\circ}$ C.

In the example, the groove 8 is given a closed shape, as a result of which an island-shaped part 4A is limited in the epitaxial layer 4.

There is etched, for example, in a flow of gas of 100 sccm/min, 14 sccm of $CH_4$, 13 sccm of He, at a pressure of 13 Pa, a high-frequency power density of $\frac{1}{2}$ W/cm$^2$, at a temperature of the silicon body of $30\,^{\circ}$ C and a frequency in the plasma of 340 kHz.

The etching rate is 140 nm/min and a groove is obtained having a substantially steep wall. The width is, for example, 0.7 μm and the depth is, for example, 7 μm. The etching rate of the thermal oxide layer 7 is low under these conditions i.e. 8 nm/min.

The insulating material 9 is obtained in that the silicon body 1 is subjected in a usual manner to an oxidizing treatment or in that material 9 containing silicon oxide is deposited from the vapour phase in the groove 8.

In the example, the substrate 2 may be of the p-conductivity type, the buried layer 3 is of the n-type and has a thickness of 3 μm and the epitaxial

layer 4 is of the p-type and has a thickness of likewise 3 μm.

In the island-shaped part 4A (cf. Figure 3), in a usual manner a transistor is formed having a collector zone 3, a base zone 4A and an emitter zone 31 as well as a collector connection zone 32. In a thin oxide layer 33, contact windows are formed, through which connections 34, 35 and 36 are provided for the emitter 31, the base 4A and the collector 3, respectively.

The invention is not limited to the example described. For example, after the groove has been etched and before the insulating material 9 is formed, an implantation of boron ions at right angles to the surface 6 may be effected to obtain channel stoppers. The invention has been described above in details for the sake of clarity. It will be clear that these details are given only for this purpose and that variations are possible for those skilled in the art without departing from the scope of the invention.

## Claims

1. A method of manufacturing a semiconductor device, in which there is etched into a monocrystalline silicon body comprising a substrate and disposed on it a highly doped buried layer and a less highly doped epitaxial layer from a free part of the surface of the epitaxial body in the silicon body in a plasma in an atmosphere containing chlorine and a carbon compound a narrow groove, which passes through the epitaxial layer and the buried layer, while the groove is filled with electrically insulating material, characterized in that the groove is etched in a plasma maintained at a frequency lower than 1 MHz.

2. A method as claimed in Claim 1, characterized in that during plasma etching a frequency of 340 kHz is used.

3. A method as claimed in Claim 1 or 2, characterized in that during plasma etching the silicon body is kept at a temperature of at most 50° C.

4. A method as claimed in Claim 3, characterized in that the temperature during plasma etching is kept at about 30° C.

5. A method as claimed in any one of the preceding Claims, characterized in that as carbon compounds one or more carbon compounds chosen from the group comprising methane, monochloromethane, dichloromethane, trichloromethane and tetrachloromethane are used.

FIG.1

FIG.2

FIG.3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | EXTENDED ABSTRACTS, vol. 80-1, May 1980, pages 307-309; R.H. BRUCE et al.: "Frequency dependence of CC14 etching" * Whole abstract * | 1,3-5 | H 01 L 21/306 |
| X | SOLID STATE TECHNOLOGY; Vol. 24, no. 10, October 1981, pages 64-68; R.H. BRUCE: "Anisotropy control in dry etching" * Figures 5-6; page 66, column 1, paragraph 4 - page 67, column 1, paragraph 1 * | 1,2,5 | |
| X | SOLID STATE TECHNOLOGY, vol. 24, no. 4, April 1984, pages 161-166; V.M. DONNELLY et al.: "Anisotropic etching in chlorine-containing plasmas" * Page 163, column 2, paragraph 2 - page 164, column 1, paragraph 2; figure 1 * | 1,2,5 | |
| A | JOURNAL VACUUM SCIENCE TECHNOLOGY, vol. 16, no. 2, March/April 1979, pages 410-413, American Vacuum Society; G.C. SCHWARTZ et al.: "Reactive ion etching of silicon" * Page 412, column 2, paragraph 2 - page 413, column 1, paragraph 2; page 413, column 1, paragraph 5 - column 2, paragraph 4 * | 1,5 | TECHNICAL FIELDS SEARCHED (Int. Cl.4) H 01 L |
| A | EXTENDED ABSTRACTS, vol. 81-2, October 1981, pages 631-633; R.H. BRUCE et al.: "Frequency effects in chlorine plasma etching" * Whole document * -/- | 1 | |

The present search report has been drawn up for all claims

| Place of search | Date of completion of the search | Examiner |
|---|---|---|
| THE HAGUE | 02-07-1989 | VANCRAEYNEST F.H. |

European Patent
Office

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | IBM TECHNICAL DISCLOSURE BULLETIN, vol. 22, no. 5, October 1979, page 1819, New York, US; P.M. SCHAIBLE et al.: "Reactive ion etching silicon" * Page 1819, paragraphs 4-5 * | 1,5 | |

TECHNICAL FIELDS
SEARCHED (Int. Cl.4)

The present search report has been drawn up for all claims

| Place of search | Date of completion of the search | Examiner |
|---|---|---|
| THE HAGUE | 02-07-1989 | VANCRAEYNEST .F.H. |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 

& : member of the same patent family, corresponding
    document

EPO FORM 1503 03.82 (P0401)